# EUROPEAN PATENT SPECIFICATION

(11) **EP 0 803 876 B1**
(45) Date of publication and mention of the grant of the patent: **17.11.2004**
(21) Application number: 97480018.7
(22) Date of filing: 08.04.1997
(51) Int. Cl.: G11C 11/418, G11C 8/00

(54) **High speed decoder without race condition**
Sehr schneller Dekodierer ohne Zeitsteuerungskonflikt
Décodeur à grande vitesse sans conflit de temporisation

(30) Priority: 23.04.1996 EP 96480048
(43) Date of publication of application: 29.10.1997
(73) Proprietor: International Business Machines Corporation, Armonk, N.Y. 10504 (US)
(72) Inventor: Gabillard, Bertrand, 75012 Paris (FR)
(74) Representative: Therias, Philippe

(56) References cited:
- DE-A- 4 207 937
- ANONYMOUS: "High Performance Complementary Decoder/Driver Circuit" IBM TECHNICAL DISCLOSURE BULLETIN, vol. 29, no. 6, pages 2390-2394, XP002123560 New York, US
- "REDUNDANT/NORMAL CLOCK GENERATION FOR REDUNDANT WORDLINE ADDRESSING" IBM TECHNICAL DISCLOSURE BULLETIN,US,IBM CORP. NEW YORK, vol. 32, no. 8A, 1 January 1990 (1990-01-01), pages 75-76, XP000082712 ISSN: 0018-8689

## Description

### Technical field

The present invention relates to high speed memory chips, and more particularly to high speed decoder improved with a self-clocked circuit avoiding race conditions.

### Background art

In high speed VLSI systems, wiring is an important parameter as it may generate unuseful internal delays which directly impact the global performance of the system. Due to chip design constraint, the signals propagate on different paths and race conditions are often occurring, leading to overlapped operations. To remedy to the situation, the worst case delays are often taken as reference delays for synchronization of signals, and generally a clock or a control signal based on this reference delay is gating the circuits to be selected. Moreover, a time margin is most often added to the worst case reference delay to be sure that all switching of signals are ended before the gating signal becomes active.

The general state of the prior art with respect to solving the race conditions problem may be best illustrated and understood with reference to several patents described now.

US-A-5,121,005 from Motorola discloses a programmable logic array (PLA) wherein the propagation paths for the control signals are made slower than the worst case data path to eliminate race conditions. The PLA operates with a single clock signal frequency which delays the control signals allowing time for the signals to reach steady state.

US-A-5,124,572 from Hewlett-Packard discloses a clocking methodology using global overlapping clocks for providing timing advantages and locally non-overlapping clocks derivative from the overlapping clocks for eliminating race conditions.

In US-A-4,544,850 from GTE, a mediator circuit is used to prevent gate delay variations from causing processing to commence after a period of time during which data is made available. The mediator circuit outputs a gated data signal provided by a data enable signal and a data signal.

In the decoders, and particularly in high speed decoders the aforementioned problem is crucial as only one line (a wordline or a pair of bitlines) has to be selected among all, otherwise a wrong data is read from or written into the memory array.

Usually, with a large number of address inputs, the decoder is split in several stages referred as predecoder, decoder, driver, wherein the address paths are different for each stage. One example of such multi-stage decoder is described in the IBM Technical Disclosure Bulletin, vol. 29, n° 6, pages 2390-2394, XP002123560, New-York, US. As a result, mistracking along these different address paths could occur, so time margins are absolutely required in order to avoid race conditions. Unfortunately these time margins are directly added to the access time, and thus decrease the overall system speed performance.

In the known multi-stage decoders, the time margin is usually added to the delay of the decoder/driver stage. A clock signal applied to the input of this stage becomes active when all predecoding signals have reached a steady state, allowing only one line to be selected.

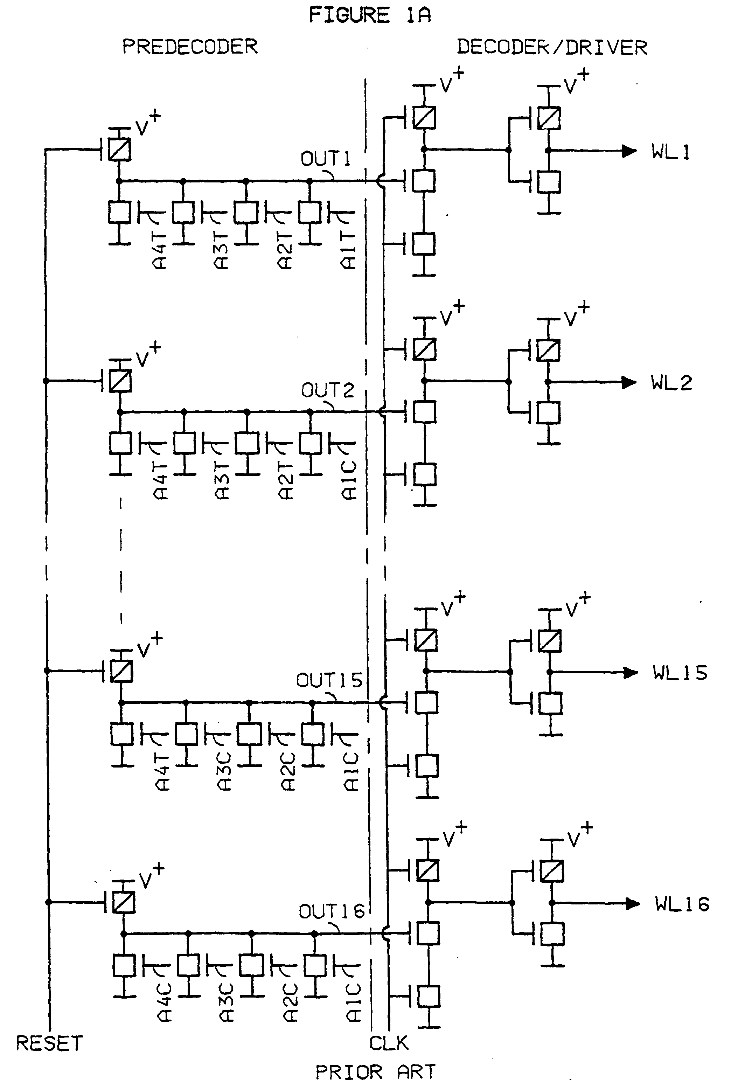

Referring to Fig.1A, a two-stage word decoder of the prior art particularly adapted for use in high speed memories and reflected in the preamble of claim 1, is illustrated. The specific details of operation of this system, which are well understood by those skilled in the art, will be omitted from this discussions. The devices of the predecoder stage are connected according to the so-called NOR-type logic, which is a fast decoding architecture. The devices of the decoder/driver stage are connected according to the so-called NAND-type logic. For simplification of the description, a 4-bit row decoding circuit is shown but the principle now described may be applied to any other x-bit row or column decoding circuit, as well as to devices processed by different technologies.

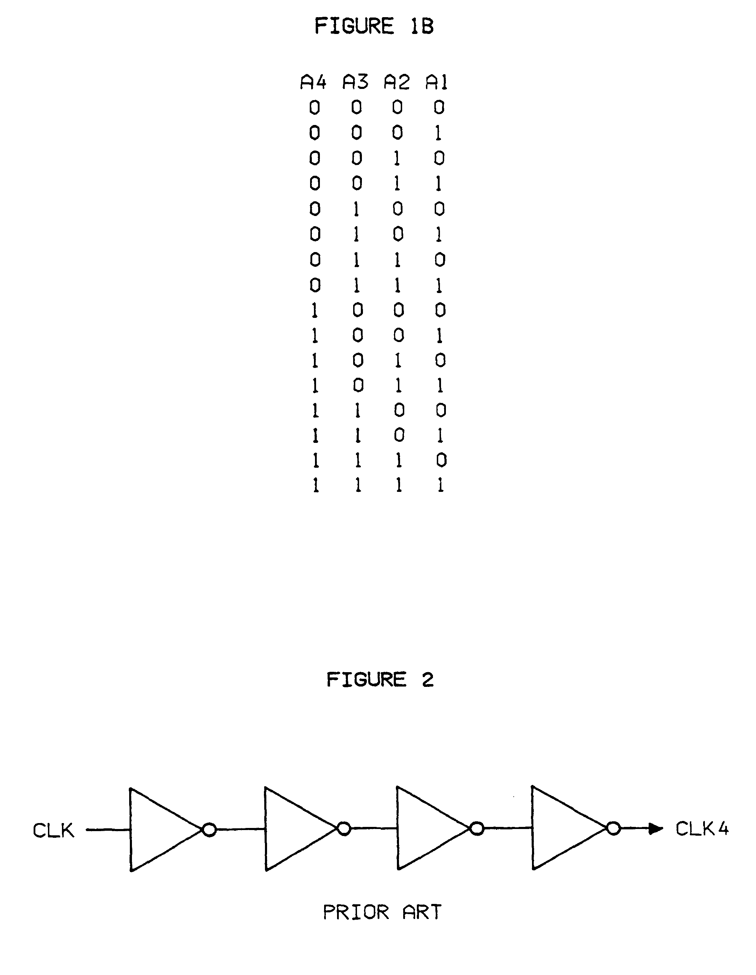

Briefly described, the predecoder stage is composed of 16 blocks, each block having four NFETs devices receiving true or complement address bits (A1T/C-A4T/C) being distributed according to a binary code table as the one of Fig.1-B.

A PFET device connected to the output of each predecoder block receives a RESET signal to tie to a high level V+ all the NOR output nodes (OUT1-OUT16) when the circuit is not active i.e. when no decoding operation is required.

Each of the sixteen decoder/driver blocks consists of a 2xways NAND gate which receives on a first input the corresponding output from the predecoder block and on a second input an asynchronous clock signal CLK. The clock signal gates the final selection of a wordline (one among the sixteen WL1-WL16).

When a cycle for selecting a wordline is initiated, the RESET signal is tied to a high level V+. According to the binary state applied on the gate of the NFET devices of each predecoder block, fifteen outputs predecoder go down to a low voltage while only one output remains high. Then the CLK signal becomes active when the slowest NOR circuit output has been discharged (i.e. the one with only one active NFET device). Even such a decoding architecture is very fast, it suffers from a risk of a multiselection wordline in case the CLK signal becomes valid before the fifteen deselections. And a time margin is added along the path of the CLK signal, such as the circuit of Fig.2, to delay the gating of the decoder/driver stage. This solution limits the risk of a multi selection, but it does not eliminate it. Unfortunately the gating delay decreases the speed performance of the system.

The drawback of such solution is that the performance of the decoder is both impacted by the longest delay in the predecoder stage moreover the delay of the time margin. Furthermore, it does not give the assurance of preventing a hazard timing from occurring, except if an excessive delay is chosen for the time margin applied to the clock signal, but it does not comply with the nowadays high speed systems.

DE 42 07 937 A from Mitsubishi illustrates on figure 14 a write row decoder formed by an inverter and an AND gate. The write row decoder selectively sets one of m word lines to high level in response to write row signals. Whereas this solution offers limiting risk of multi-selection, some improvements may be proposed.

Accordingly, it would be desirable to be able to provide a new and improved decoder which eliminates the aforementioned delay resulting from race condition.

### Summary of the invention

It is an object of this invention to provide an apparatus for achieving a self-clocked circuit for use in connection with decoder systems.

It is another object of the invention to provide an apparatus for avoiding race condition in memory systems selected in a group comprising various Random Access Memories (RAM) and Read Only Memories (ROM), such as SRAM, DRAM, GRAM, EPROM,...

It is yet another object of the invention to provide improved decoder systems that exhibit operating characteristics that are enhanced by virtue of including the cross-coupled circuit of the invention.

Still further, it is an object of the invention to provide improved methods for enhancing the performance of decoder systems in general.

The multi-stage decoder circuit of the invention is described in claim 1.

In a preferred embodiment the gating signals output from said gating means are the inverted phase of the ith/jth output signals of corresponding predecoder blocks.

In another embodiment, the gating means are connected between two predecoder/driver blocks receiving consecutive binary addresses, according to a binary code.

In yet another embodiment, the self-clocked apparatus of the invention is used for either a word decoder or a bit decoder.

### Brief description of the drawings

Fig.1-A shows a typical multi-stage word decoder with address paths wired according to a 4-bit binary code.
Fig.1-B shows a 4-bit binary code table.
Fig.2 shows a time margin circuit of the prior art.
Fig.3 is a block diagram of the cross-connected circuit of the invention, not showing all features of the invention.
Fig.4 is a circuit diagram of an examplary circuit not covered by the invention.
Fig.5-A and fig.5-B are timing diagrams of a word decoder employing a self-clocked circuit
Fig.6 shows the circuit of the invention, wherein a 3xways NAND is used.

### Detailed description of the invention

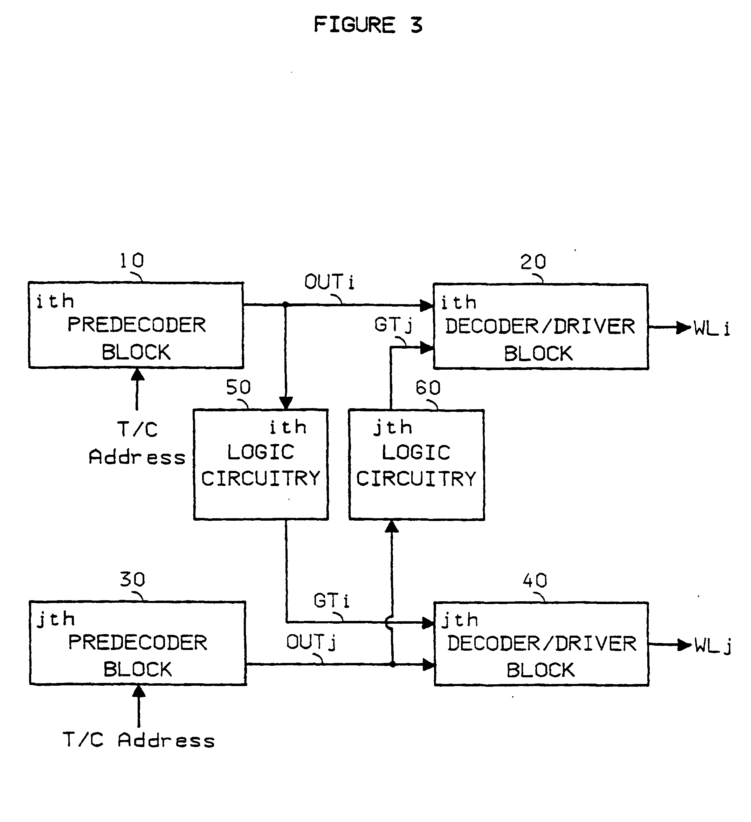

Referring now to Fig.3 showing a block diagram of the circuit of the invention used in a word decoder, the principle is described hereinafter for a pair of ith and jth blocks.

The block diagram, however, does not show all the features of the invention as defined in claim 1.

A ith predecoder block (10) receives true/complement address bits, and outputs a predecoding output signal OUTi.

The output OUTi of predecoder block (10) is input to a corresponding ith decoder/driver block (20), which outputs a wordline signal WLi.

A jth predecoder block (30) receives true/complement address bits, and outputs a predecoding output signal OUTj.

The output OUTj of predecoder block (30) is input to a corresponding jth decoder/driver block (40), which outputs a wordline signal WLj.

The ith decoder/driver block (20) also inputs a signal GTj provided from a jth logic circuitry (60) which inputs the output signal OUTj of the jth predecoder block (30).

The jth decoder/driver block (40) also inputs a signal GTi provided from a ith logic circuitry (50) which inputs the output signal OUTi of the ith predecoder block (10).

The self-clocked logic circuitry (50,60), is cross-connected between the ith and jth blocks such that the ith decoder/driver block is controlled by the jth predecoder block to ultimately select a wordline, and conversely.

The decoder is composed of a predecoder stage with circuit blocks of a NOR-type and a decoder/driver stage with circuit blocks of a NAND-type (as the decoder shown on Fig.1-A).

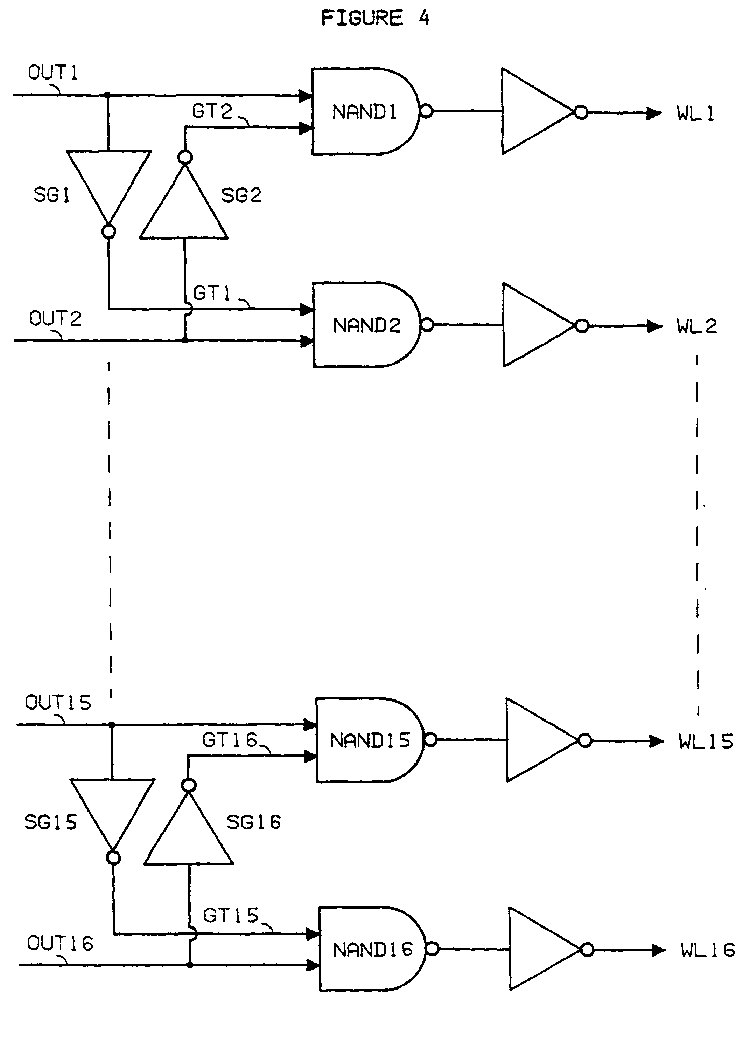

Fig.4 illustrates an exemplary circuit not covered by the invention, but useful for its understanding, with the two top NOR-type predecoder blocks (not shown) outputting signals OUT1, OUT2 with corresponding NAND-type decoder/driver blocks outputting wordline signals WL1, WL2.

Fig.4 also shows the circuit of the invention connected between the two bottom NOR-type predecoder blocks (not shown) outputting signals OUT15, OUT16 with corresponding NAND-type decoder/driver blocks outputting wordline signals WL15, WL16.

Between these top and bottom pairs of blocks, the circuit of the invention is regularly connected between two blocks, and the same cross-connection is similarly repeated for all the decoder circuit.

In this example, the cross-connection is made between two adjacent predecoder blocks, but it can be made between non adjacent blocks.

Output OUT1 as discussed above is connected to one input of a 2xWays NAND gate NAND1 of a first decoder/driver block, while output OUT2 is connected to one input of a 2xWays NAND gate NAND2 of a second decoder/driver block.

Outputs (OUTI, OUT2) are respectively also inputs to logic circuitry which in a further example not covered by the invention are the inverters SG1 and SG2. The inverted output GT1 of inverter SG1 is connected to the second input of the 2xWays NAND2, while the inverted output GT2 of inverter SG2 is connected to the second input of the 2xWays NAND1.

As previously discussed, when no selection of wordline is required, i.e. when the memory is not addressed, all the outputs OUT1-OUT16 are tied to a high level, corresponding to a "1" logical value on a first input of NAND1 and NAND2.

Inverters SG1 and SG2 invert the data so that inputs "1" from outputs OUT1 and OUT2 are output as a "0" logical value. The output "0" of inverter SG1 is the second input of NAND2, and the output "0" of inverter SG2 is the second input of NAND1, respectively. Therefore each gate NAND1 and NAND2 detects a (1,0) binary state, which is a binary condition to tie to a low level the wordline signals WL1 and WL2. In the same manner, all the NAND gates detect a (1,0) binary state, then all the wordline signals Wli are tied to a low level, and no wordline is selected.

Now in the operating mode, when the memory is addressed, true/complement address bits are pulsed either to a high or low level ("1" or "0" logical value), depending on the value of the address to be selected. Then outputs of predecoder blocks receiving a binary state comprising at least a logical "1" discharges thru the active devices (not shown but identical to Fig.1.A). The output of the sole predecoder block receiving a binary state composed only of "0" remains high.

It is assumed that according to Fig.4, OUT1 remains high while OUT2 discharge. The output of inverter SG1 remains unchanged, i.e. a logical "0", while the output of inverter SG2 goes up to a high level.

Therefore the binary state on the input of NAND1 becomes a (1,1) which is the only case for the wordline signal WL1 to charge to a high level, and then to select the corresponding memory cell in the memory array.

The binary state on the input of NAND2 changes from (1,0) to (0,0) due to the discharge of output OUT2. As a binary state (0,0) is an equivalent state for a NAND logical gate than a binary state (1,0), the final output does not change, and thus the wordline signal WL2 remains low.

Because one input of 2xWays NAND2 remains low (GT1 from the output of inverter SG1), there is no risk for the final output of NAND2 to be selected. In fact, the discharge of OUT2 is a confirmation of the unselection of WL2. While the above operation has been described for a pair of decoder blocks comprising the selected wordline, a similar operation is now described for one of any of the others pairs of decoder blocks, comprising two unselected wordlines.

As shown on Fig.4, the bottom pair of blocks comprises two wordline signals (WL15,WL16). The outputs (OUT15,OUT16) of predecoder blocks are such that when the memory is addressed, both outputs discharge thru the active devices (devices receiving a logical "1" on their gate input, as shown on Fig.1A).

Then the inverted outputs of inverters SG15 and SG16 go up to a high level, respectively. Therefore the binary state on the input of gate NAND15 as well as gate NAND16 changes from (1,0) to (0,1).

While a steady state (0,1) is equivalent of a steady state (1,0) for a logical 2xWays NAND gate (i.e. logical "0" on the output), the transition phase from one state to the other may involve a risk of detecting a (1,1) logical state during a short time, and then modifying the NAND gate output.

This situation could occur with an implementation of the circuit of the invention, only if the output of one predecoder block discharges slowly while the output of the cross-connected predecoder block discharges rapidly. Such a case is possible if the cross-connection of the self-clocked circuit is made between predecoder blocks receiving true/complement address bits such that the number of active devices in one predecoder block is very different that the number of active devices of the other predecoder block, during an operation of selection. The worst case is when the number of active devices in one predecoder block is twice the number of active devices in the cross-connected predecoder block.

Therefore, the circuit of the invention is cross-connected between predecoder blocks receiving consecutive binary addresses. Then the number of active devices in each predecoder block differs only by one, and the discharging time for both blocks is about the same, eliminating thus the risk of multiselection.

Furthermore, in order to improve the efficiency of the circuit of the invention, the devices implemented in the logic circuitry are well dimensioned thereby reducing the risk of a multiselection.

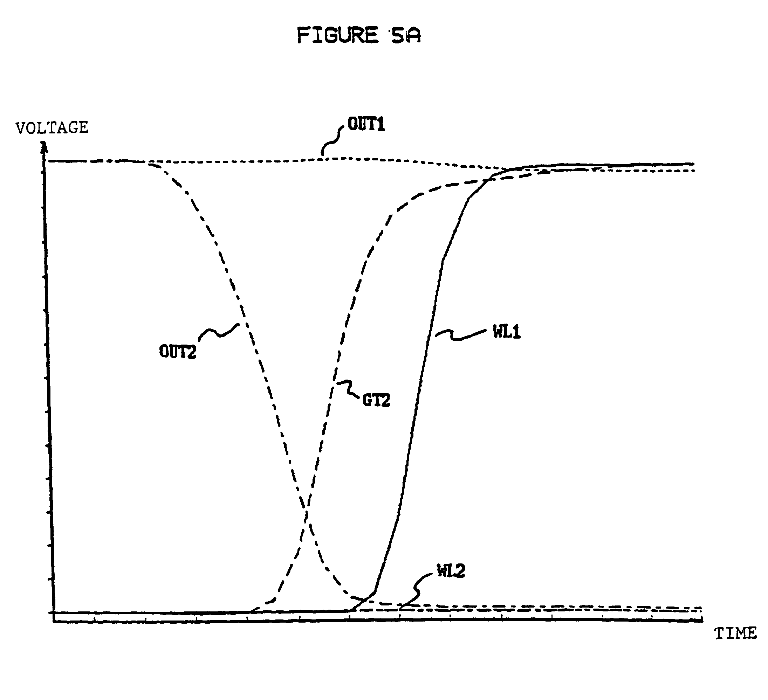

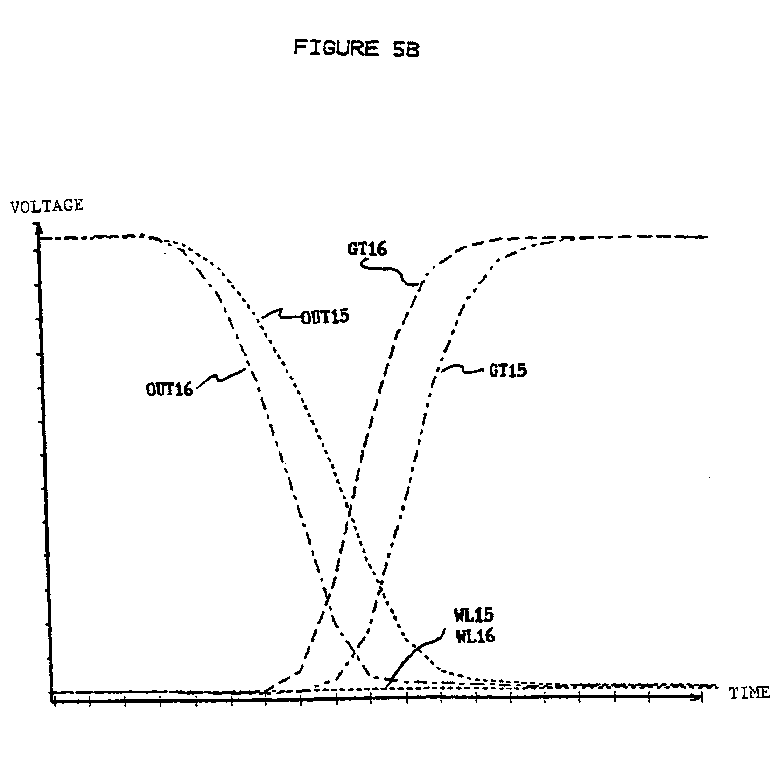

Fig.5 A and Fig.5 B are timing diagrams illustrating various outputs of a decoder for a cross-connection of the self-clocked circuit of the invention, made between adjacent predecoder blocks.

As a result of the aforementioned example, the advantage of the invention is that the internal timing of the ith decoder/driver block is controlled by the i+1th predecoder block, and conversely. Then, an external clock signal can be removed, and the time margins used in the prior art decoder design can also be removed. Furthermore, as the cross-connected blocks are adjacent they closely track together and therefore the invention provide a robust electrical design.

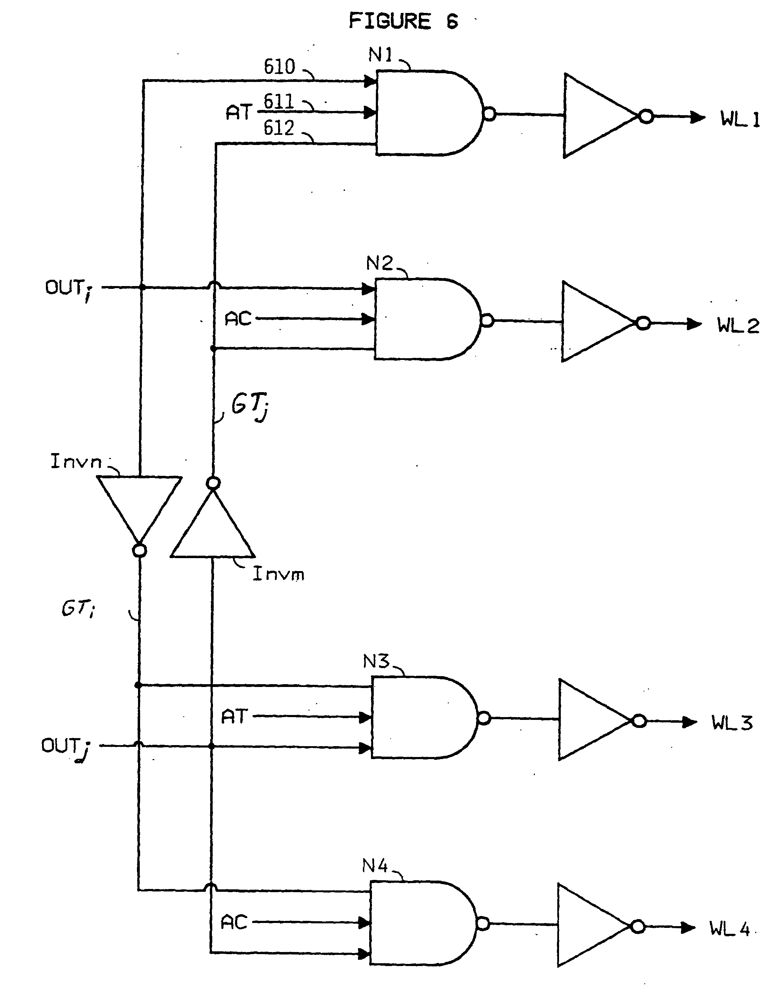

Fig. 6 shows a circuit according to the invention, based on the use of a known high speed decoder wherein the decoder comprises a first predecoder stage and a second decoder/driver stage in which each decoder/driver block is composed of two sub decoder/driver blocks connected to a common predecoder block. Each sub decoder/driver block comprises a 3xWays NAND gate, each one receiving:
- on a first input (610) the output (OUTi,OUTj) of the common predecoder block,
- on a second input (611) a true or complement (AT,AC) address bit, and
- on a third input (612) the output (GTj,GTi) of a self-clocked circuit cross-connected with a second predecoder block.

In such implementation, each self-clocked block circuit is arranged to clock four word lines. The inventor measured that the invention is enable to reduce the access time of a SRAM by about 700 ps to 800 ps.

## Claims

1. A multi-stage decoder circuit having at least a first stage composed of n predecoder blocks of NOR-type logic circuitry and a second stage composed of n decoder/driver blocks of NAND-type logic circuitry, each ith predecoder block (10) receiving at least a pair of true or complement address bits and outputting a high or low level ith output signal (OUTi) depending on the address bits state, each ith decoder/driver block (20) receiving at least the ith output signal (OUTi) from the corresponding predecoder block (10) and outputting an ith selection signal (WLi) selecting or not selecting a connected line,
the multi-stage decoder circuit being **characterized by** a self-clocked apparatus comprising a first gating means (50,lnvn) connected between the ith predecoder block (10) and the jth decoder/driver block (40) and a second gating means (60,lnvm) connected between the jth predecoder block (30) and the ith decoder/driver block (20), and wherein the first gating means (50, lnvn) inputting said ith output signal (OUTi) and outputting an ith gating signal (GTi), the ith gating signal (GTi) being applied on said jth decoder/driver block for gating a jth output signal (OUTj) and the second gating means (60,lnvm) inputting said jth output signal (OUTj) and outputting a jth gating signal (GTj), the jth gating signal (GTj) being applied on said ith decoder/driver block for gating said ith output signal (OUTi);
the multi-stage decoder circuit being further **characterized in that** each ith decoder/driver block (20) comprises two 3xWays NAND gates (N1,N2) receiving respectively a true or complement address bit (AT,AC), further receiving said ith output signal (OUTi) and said jth gating signal (GTj).

2. The multi-stage decoder circuit of claim 1 wherein the gating signals (GTi,GTj) output from said gating means (50,60) are the inverted phase of the ith/jth output signals (OUTi, OUTj) of corresponding predecoder blocks (10,30).

3. The multi-stage decoder circuit of claim 1 or 2 wherein said first and second gating means (50,60) are connected between two predecoder/driver blocks (10,30) receiving consecutive binary addresses.

4. The multi-stage decoder circuit of anyone of claims 1 to 3 wherein said decoder is a wordline decoder.

5. The multi-stage decoder circuit of anyone of claims 1 to 3 wherein said decoder is a bitline decoder.

6. The multi-stage decoder circuit of anyone of claims 1 to 5 wherein said multi-stage decoder is used in a memory system selected in a group consisting of SRAM, DRAM, GRAM, ROM, EPROM.

## Patentansprüche

1. Mehrstufendecodiererschaltung, die mindestens eine erste Stufe, welche aus n Vordecodiererblöcken mit Logikschaltungen vom NOR-Typ besteht, und eine zweite Stufe, die aus n Decodierer-/Treiberblöcken mit Logikschaltungen vom NAND-Typ besteht, hat, wobei jeder i-te Vordecodiererblock (10) mindestens ein Paar echte oder komplementäre Adressbits empfängt und in Abhängigkeit vom Zustand der Adressbits ein auf "HIGH" oder "LOW" gesetztes i-tes Ausgangssignal (OUTi) ausgibt, wobei jeder i-te Decodierer-/Treiberblock (20) mindestens das i-te Ausgangssignal (OUTi) von dem entsprechenden Vordecodiererblock (10) empfängt und ein i-tes Auswahlsignal (WLi) ausgibt, das eine angeschlossene Leitung auswählt oder nicht auswählt,
wobei die Mehrstufendecodiererschaltung durch eine selbstgetaktete Vorrichtung gekennzeichnet ist, die ein erstes Ansteuermittel (50, Invn), das zwischen dem i-ten Vordecodiererblock (10) und dem j-ten Decodierer-/Treiberblock (40) angeschlossen ist, und ein zweites Ansteuermittel (60, Invm), das zwischen dem j-ten Vordecodiererblock (30) und dem i-ten Decodierer-/Treiberblock (20) angeschlossen ist, umfasst und wobei das erste Ansteuermittel (50, Invn) das i-te Ausgangssignal (OUTi) eingibt und ein i-tes Ansteuersignal (GTi) ausgibt, wobei das i-te Ansteuersignal (GTi) an den j-ten Decodierer-/Treiberblock angelegt wird, um ein j-tes Ausgangssignal (OUTj) durchzuschalten, und wobei das zweite Ansteuermittel (60, Invm) das j-te Ausgangssignal (OUTj) eingibt und ein j-tes Ansteuersignal (GTj) ausgibt, wobei das j-te Ansteuersignal (GTj) an den i-ten Decodierer-/Treiberblock angelegt wird, um das i-te Ausgangssignal (OUTi) durchzuschalten;
wobei die Mehrstufendecodiererschaltung ferner **dadurch gekennzeichnet ist, dass** jeder i-te Decodierer-/Treiberblock (20) zwei NAND-Gatter mit jeweils drei Eingängen (N1, N2) umfasst, die jeweils ein echtes oder ein komplementäres Adressbit (AT, AC) und darüber hinaus das i-te Ausgangssignal (OUTi) und das j-te Ansteuersignal (GTj) empfangen.

2. Mehrstufendecodiererschaltung nach Anspruch 1, wobei die von dem Ansteuermittel (50, 60) ausgegebenen Ansteuersignale (GTi, GTj) die invertierte Phase der i-ten/j-ten Ausgangssignale (OUTi, OUTj) von entsprechenden Vordecodiererblöcken (10, 30) sind.

3. Mehrstufendecodiererschaltung nach Anspruch 1 oder 2, wobei das erste und das zweite Ansteuermittel (50, 60) zwischen zwei Vordecodierer-/Treiberblöcken (10, 30) angeschlossen sind, die aufeinanderfolgende Binäradressen empfangen.

4. Mehrstufendecodiererschaltung nach einem der Ansprüche 1 bis 3, wobei der Decodierer ein Wortleitungsdecodierer ist.

5. Mehrstufendecodiererschaltung nach einem der Ansprüche 1 bis 3, wobei der Decodierer ein Bitleitungsdecodierer ist.

6. Mehrstufendecodiererschaltung nach einem der Ansprüche 1 bis 5, wobei der Mehrstufendecodierer in einem Speichersystem verwendet wird, das aus einer aus SRAM, DRAM, GRAM, ROM, EPROM bestehenden Gruppe ausgewählt wird.

## Revendications

1. Circuit de décodeur à étages multiples comportant au moins un premier étage composé de n blocs de prédécodeurs de circuits logiques de type NON OU (NOR) et un second étage composé de n blocs de décodeurs/circuits d'attaque de circuits logiques de type NON ET (NAND) chaque i^{e} bloc de prédécodeur (10) recevant au moins une paire de bits d'adresse réels et complémentaires et fournissant en sortie un i^{e} signal de sortie au niveau haut ou bas (OUTi) suivant l'état des bits d'adresse, chaque i^{e} bloc de décodeur/circuit d'attaque (20) recevant au moins le i^{e} signal de sortie (OUTi) du bloc de prédécodeur correspondant (10) et fournissant en sortie un i^{e} signal de sélection (WLi) sélectionnant ou ne sélectionnant pas une ligne reliée,
le circuit de décodeur à étages multiples étant **caractérisé par** un dispositif auto-cadencé comprenant un premier moyen de sélection par porte (50, Invn) relié entre le i^{e} bloc de prédécodeur (10) et le j^{e} bloc de décodeur/circuit d'attaque (40) et un second moyen de sélection par porte (60, Invm) relié entre le j^{e} bloc de prédécodeur (30) et le i^{e} bloc de décodeur/circuit d'attaque (20) et dans lequel le premier moyen de sélection par porte (50, Invn) reçoit en entrée ledit i^{e} signal de sortie (OUTi) et fournit en sortie un i^{e} signal de sélection par porte (GTi), le i^{e} signal de sélection par porte (GTi) étant appliqué sur ledit j^{e} bloc de décodeur/circuit d'attaque afin de sélectionner par porte un j^{e} signal de sortie (OUTj) et le second moyen de sélection par porte (60, Invm) recevant en entrée ledit j^{e} signal de sortie (OUTj) et fournissant en sortie un j^{e} signal de sélection par porte (GTj), le j^{e} signal de sélection par porte (GTj) étant appliqué sur ledit i^{e} bloc de décodeur/circuit d'attaque afin de sélectionner par porte ledit i^{e} signal de sortie (OUTi),
le circuit de décodeur à étages multiples étant en outre **caractérisé en ce que** chaque i^{e} bloc de décodeur/circuit d'attaque (20) comprend deux portes NON ET à trois entrées (N1, N2) recevant respectivement un bit d'adresse réel ou de complément (AT, AC), recevant en outre ledit i^{e} signal de sortie (OUTi) et ledit j^{e} signal de sélection par porte (GTj).

2. Circuit de décodeur à étages multiples selon la revendication 1, dans lequel les signaux de sélection par porte (GTi, GTj) fournis en sortie depuis ledit moyen de sélection par porte (50, 60) représentent la phase inversée des i^{e}/j^{e} signaux de sortie (OUTi, OUTj) des blocs de prédécodeurs correspondants (10, 30).

3. Circuit de décodeur à étages multiples selon la revendication 1 ou 2, dans lequel lesdits premier et second moyens de sélection par porte (50, 60) sont reliés entre deux blocs de prédécodeur/circuit d'attaque (10, 30) recevant des adresses binaires consécutives.

4. Circuit de décodeur à étages multiples selon l'une quelconque des revendications 1 à 3, dans lequel ledit décodeur est un décodeur de ligne de mots.

5. Circuit de décodeur à étages multiples selon l'une quelconque des revendications 1 à 3, dans lequel ledit décodeur est un décodeur de ligne de bit.

6. Circuit de décodeur à étages multiples selon l'une quelconque des revendications 1 à 5, dans lequel ledit décodeur à étages multiples est utilisé dans un système de mémoire sélectionné dans un groupe constitué de mémoires vives de type SRAM, DRAM, GRAM et de mémoires mortes de type ROM, EPROM.
